# EUROPEAN PATENT APPLICATION

(11) **EP 4 401 110 A1**
(43) Date of publication of application: **17.07.2024**
(21) Application number: 23151135.3
(22) Date of filing: 11.01.2023
(51) Int. Cl.: H01J 37/32, C23C 16/448

(54) **PLASMA COATING METHOD AND APPARATUS FOR SMALL COMPONENTS**

(71) Applicant: Molecular Plasma Group S.A., 3895 Foetz (LU)
(72) Inventor: HEYBERGER, Régis, F-57100 Thionville (FR); SCHONS, Bertrand, F-57190 Florange (FR); NISOL, Bernard, B-6780 Messancy (BE)
(74) Representative: IPLodge bv

(57) **Abstract**

The present invention concerns an apparatus for plasma coating three-dimensional (3D) objects with a full coating, comprising a plasma reactor and an essentially cylindrically shaped afterglow chamber, wherein the plasma reactor is configured to provide a precursor-comprising plasma flow at a plasma reactor outlet, wherein the afterglow chamber comprising a plasma inlet, an object inlet, an azimuthal flow inlet and a set of gas outlets, wherein: - the afterglow chamber is configured to receive and hold a set of 3D objects which are to be coated; - the object inlet is configured to allow the 3D objects to be inserted into and extracted out of the afterglow chamber, whereby the object inlet is sealable; - the plasma inlet is in fluid connection with the plasma reactor outlet and is configured to allow a precursor-comprising plasma flow to enter the afterglow chamber, - the azimuthal flow inlet is configured to ensure an essentially azimuthal flow within the afterglow chamber upon providing a gas flow to said azimuthal flow inlet, and - the set of gas outlets are configured to allow evacuation of surplus gas from the afterglow chamber such that both the precursor-comprising plasma flow and the azimuthal flow can be maintained.

## Description

### Technical field

The present invention pertains to the field of plasma coating methods and apparatuses, more in particular methods and apparatuses intended to provide small components with a plasma coating at atmospheric pressure.

### Background

Plasma coating is a technique whereby a coating is deposited on a substrate using a precursor. Hereby the precursor is excited to make it more reactive such that it can more easily form a high-quality coating on the substrate. Excitation of the precursor is obtained via a plasma process, either directly or indirectly.

In a direct plasma coating process, a fluid comprising the precursor is plasmized e.g. by making the fluid flow through a set of electrodes which strike a plasma into the fluid by application of a high voltage. In such direct process, the precursor can be directly excited. The excited precursor can then be made to interact with a substrate, thereby forming a coating onto the substrate.

In an indirect plasma coating process, a process fluid, preferably a process gas, is plasmized, e.g. by making the process fluid flow between a set of electrodes which can strike a plasma in the process fluid by application of a high voltage. The plasmized process gas then leaves the plasma zone, i.e. it leaves the zone wherein plasma is actively induced, which substantially coincides with the zone between the set of electrodes. A precursor-comprising fluid is then mixed with the plasmized process gas in the plasma afterglow. The precursor is then excited within this mixture due to secondary interaction with the plasmized process gas, rendering the precursor more reactive for allowing a coating to be formed on a substrate being exposed to the mixture and the excited precursor in said mixture.

Plasma coating processes may be performed at atmospheric processes or at vacuum pressure. The current invention is particularly relevant for plasma coating processes at atmospheric pressure. In atmospheric pressure plasma coating processes, the substrate is subjected to the mixture comprising said excited precursor at essentially atmospheric pressure. This has the particular advantage that the there is no requirement for vacuum technology and that the substate can be continuously treated e.g. by moving the substrate through the mixture and/or by flowing the mixture over the substrate. This is in contract with vacuum pressure plasma coating pressure, whereby it is always a hassle to ensure low pressure at the position of the substrate's exposure to the mixture. Furthermore, atmospheric pressure plasma coating processes have the further advantage that it tends to be easier to transport many different types of precursors to the plasma zone and/or the plasma afterglow region.

The present invention is preferably situated in the field of indirect atmospheric pressure plasma coating processes. Furthermore, the present invention is also preferably situated in the field of low temperature plasma coating processes, whereby the temperature of the plasma and the temperature of the mixture comprising the excited precursor typically lower is than 200°C, and preferably around room temperature. This already sets a constraint on the method for transporting the precursor: if the precursor is vaporized in order to be easily mixed with the plasmized process gas, the mixture may have a high temperature, depending on a number of factors such as the vaporization temperature of the precursor and the flow rates of the process gas and the vaporized precursor. For many precursors, and in particular for high-mass precursors, the vaporization temperature may be very high, such that the temperature of the mixture is high. In such cases, the substrate may actually be affected by the high temperature, e.g. certain polymer substrates may melt, deformation due to the temperature gradients may occur, the coating may not stick to the substrate after cooling, etc. In order to overcome this problem, the precursor can be transported to the process gas in the form of an aerosol.

Plasma coating allows forming a coating on 3D objects. In this respect, plasma coating is particularly better suited than wet coating techniques wherein a liquefied precursor is deposited (e.g. by dipping or spraying) on the substrate, because of the higher penetration of plasma as compared to liquid. The plasma coating technique, and in particular the indirect plasma coating technique, thus allows many types of precursors to be deposited on intricate 3D structures.

One problem occurring with providing a complete coating on 3D objects is how to support the 3D structures in such a way that the full surface of the 3D object is coated. Indeed, if the 3D object is supported mechanically, a portion of its surface contacts the support structure and cannot be easily coated. Hence, such a technique requires e.g. repositioning of the 3D object in order to coat it completely. Repositioning leads to an additional problem that the provided coating will not be homogeneous on all portions of the surface of the 3D object.

The present invention aims to overcome the above problem by providing a method and apparatus which allows to provide a complete coating on 3D objects, preferably solid 3D objects. Typical objects which can be treated with the present invention are components of machineries, such as gears, screws, bolts, etc. but also other objects such as crystals, computer chips, plugs, etc.

### Summary of the invention

The present invention concerns an apparatus for plasma coating three-dimensional (3D) objects with a full coating, comprising a plasma reactor and an essentially cylindrically shaped afterglow chamber comprising a plasma inlet, an object inlet, an azimuthal flow inlet and a set of gas outlets. The plasma reactor is configured to provide a precursor-comprising plasma flow at a plasma reactor outlet. The afterglow chamber can receive and hold a set of 3D objects which are to be coated. The object inlet allows insertion into and extraction out of the afterglow chamber of the 3D objects which are to be coated. The object inlet can be sealed off. The plasma inlet is in fluid connection with the plasma reactor outlet and allows a precursor-comprising plasma flow to enter the afterglow chamber. The azimuthal flow inlet is configured to ensure an essentially azimuthal flow within the afterglow chamber upon providing a gas flow to said azimuthal flow inlet. This can preferably be achieved by the azimuthal flow inlet being oriented azimuthally to the essentially cylindrically shaped afterglow chamber. The set of gas outlets allow evacuation of the surplus gas from the afterglow chamber such that both the precursor-comprising plasma flow and the azimuthal flow can be maintained.

Accordingly, the present invention also concerns a method for plasma coating three-dimensional (3D) objects with a full coating, comprising the steps of:
(a) inserting a set of 3D objects into an essentially cylindrically shaped afterglow chamber;
(b) creating an essentially azimuthal flow in said afterglow chamber, thereby essentially inducing randomized rotational and translational movement of the 3D objects, and
(c) providing a precursor-comprising plasma flow to the afterglow chamber during said movement of the 3D objects, thereby providing a coating on the 3D objects.

Preferably, the precursor-comprising plasma flow is created by plasmizing a process gas at about atmospheric pressure, and by subsequently mixing a precursor into the plasmized process gas, thereby creating an indirect atmospheric pressure plasma which is provided to the afterglow chamber as said precursor-comprising plasma flow.

Preferably, the essentially azimuthal flow is created by a circulating gas provided to the afterglow chamber via an azimuthal flow inlet of the afterglow chamber, said azimuthal flow inlet being oriented azimuthally to the essentially cylindrically shaped afterglow chamber.

### Overview of the figures

**Figure 1** shows an apparatus according to the present invention.
**Figure 2** illustrates an afterglow chamber in accordance with the present invention.
**Figures 3A, 3B****,** **4A and 4B** compare uncoated 3D objects with 3D objects coated in accordance with the present invention.

### Detailed description of the invention

The present invention concerns an apparatus and a method for plasma coating three-dimensional (3D) objects with a full coating as in claims 1 and 3.

The invention has the particular advantage that it allows 3D objects of any shape to be coated using a plasma coating technique, which allows nanocoatings to be formed all over the surface of the objects. Typically, coatings having a thickness of between 1 nm and 2000nm, more typically between 10nm and 1 000nm, can be deposited. The thickness of the coating is also essentially equal over the full surface of the objects. The shape of the objects may comprise any regular or irregular form. Preferably, the 3D objects which are coated together, have the same shape and/or size and/or comprise the same materials, more preferably said 3D objects are essentially identical. However, the present invention has the advantage of being able to coat different types of 3D objects, even during the same batch. Hence, in an embodiment, at least two of the 3D objects are non-identical.

In order to coat the 3D objects, these are inserted in the afterglow chamber, via an object inlet such as preferably an opening in the mantle surface of the essentially cylindrical afterglow chamber. The object inlet is then preferably closed off to lock in the 3D objects and/or to ensure that the intended flow in the afterglow chamber is not influenced by the object inlet. An azimuthal flow is then induced in the afterglow chamber, preferably by injecting a circulation gas through an azimuthal opening in the afterglow chamber. Preferable the circulation gas is the same gas as the plasma process gas. For instance, if the process gas, which is used to create the precursor-comprising plasma flow, is nitrogen (N2) gas, then the circulation gas which is used to create the azimuthal flow in the afterglow chamber, is preferably also nitrogen gas.

The afterglow chamber is essentially cylindrical having a central axis which defines an axial direction. A radial direction then can be defined as the direction perpendicular to the central axis and directed straight away from the central axis. The term "azimuthal" refers to a direction perpendicular to the central axis and the radial direction and thus refers to a direction around the central axis.

Due to the azimuthal flow, the 3D objects are blown through the afterglow chamber, each of them thereby rotating and being exposed to the precursor-comprising plasma flow from all sides. This allows coating on all sides of the 3D objects. The present invention therefore offers much better results with respect to coating homogeneity and processing speed than methods which use for instance a positioning table onto which the objects are lying, whereby the upper side of the objects are first coated, after which the objects are turned and the other side thereof is coated. Note also, that other methods may require a specifically designed supporting table or supporting configuration for the objects in case they have a very particular or irregular shape. Such a specialized supporting table is not required in the present invention since the object are unsupported in the present invention.

The 3D objects which can be treated comprise a maximum size which preferably is at least 0.1 mm and/or at most 20.0 mm, more preferably at least 0.2 mm and/or at most 10.0 mm. Most preferably the 3D objects comprise a maximum size of at least 0.5 mm in each dimension. Notwithstanding this preferred lower limit to the minimum size, the present invention can also be applied for 3D objects comprising a maximum size smaller than 0.1 mm.

Note that when referring to an object comprising a maximum size of at least 'x' mm, we refer to the largest linear distance between two positions of the object. For instance, if the object is cylindrical of diameter d and height h, the maximum size is the square-root of (d²+h²).

Note that the 3D objects may also comprise particulate matter, e.g. powder. In the present context, particulate matter refers to small matter typically comprising a maximum size of less than 0.2 mm. Although the method and apparatus of the present invention are capable of plasma coating such particulate matter, the effects obtained by the azimuthal flow and/or the azimuthal flow inlet are more pronounced for larger 3D objects.

It is an advantage of the present invention that it can be used for coating 3D objects of many types and many materials, preferably comprising any or any combination of metals, polymer, ceramics, wood, sugar.

It is an advantage of the present invention that it can be used for coating 3D objects having a density within an extensive range of values, e.g. from 0.1 g/cm³ to 25.0 g/cm³.

Preferably the 3D objects each comprise a mass which is at least 0.1 mg and/or at most 10.0 g, preferably at least 1 mg and/or at most 1 g.

The present invention will be further described with references to the figures.

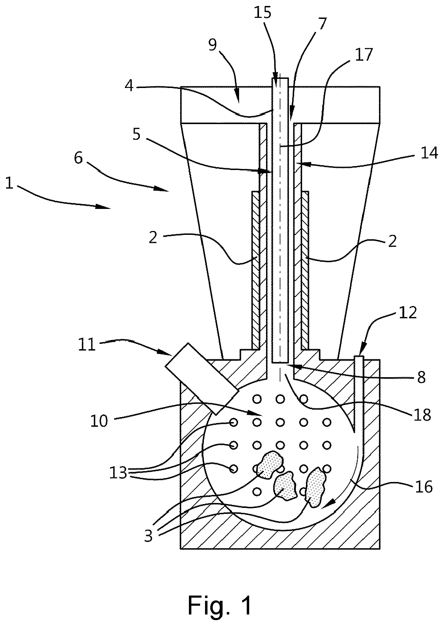

Fig. 1 shows an apparatus (1) according to the present invention. The essentially afterglow chamber (10) is shown in a cross sectional view, thereby showing an essentially circular cross section. Preferably, the afterglow chamber (10) comprises a height which is measured perpendicular to the circular cross section, said height preferably being less than a diameter of the circular cross section. This tends to ensure a better azimuthal flow. A set of 3D objects (3) is present in the afterglow chamber (10), the objects having an irregular form. An azimuthal flow (16) can be induced in the afterglow chamber by flowing a circulation gas through the azimuthal flow inlet (12). Consequently, the 3D objects are made to move within the afterglow chamber in an essentially random manner, which in turn will ensure a very homogeneous coating layer to be formed on each object.

In an embodiment, plasma can be created in the reactor (6) of the apparatus, said reactor comprising a plasma discharge chamber (5). Preferably, the plasma is ignited using a set of electrodes (2, 4), which preferably are positioned along the plasma discharge chamber. As illustrated in fig. 1 a first electrode (2), preferably an AC electrode, is preferably positioned on an outer side of the plasma discharge chamber and a second electrode (4), preferably an earthing electrode, is preferably positioned essentially on an inner side of the plasma discharge chamber. Preferably, a dielectric (14) is provided shielding the first electrode (2) from the lumen of the plasma discharge chamber. A process gas (9) can be provided at the plasma discharge chamber inlet (7), and can be made to flow through the plasma discharge chamber, thereby creating a plasmized plasma gas. The plasma discharge chamber is hereby defined by the second electrode (4) and the dielectric (13). The first electrode (2), the dielectric (14) and second electrode (4) form a dielectric barrier discharge plasma torch which can be arranged to continuously plasmize process gas flowing through the plasma discharge chamber.

In a preferred embodiment, the second electrode (4), comprises a internal channel (17) through which a precursor can be made to flow from a precursor inlet (15) to the plasma reactor outlet. The precursor can be provided as a gas or an aerosol, preferably as an aerosol. The precursor is mixed with the plasmized process gas at or near the plasma reactor outlet (8), which is fluidly connected to the afterglow chamber (10) via the plasma inlet (18) of the afterglow chamber. Consequently, a precursor-comprising plasma flow is made to enter the afterglow chamber. Note that the electrodes and/or the plasma zone, i.e. the zone where plasma is actively induced, are preferably located outside of the afterglow chamber. Hence, the 3D objects are preferably exposed to the afterglow of the precursor-comprising plasma flow.

The 3D objects can be provided to the afterglow chamber and removed from the afterglow chamber via an object inlet (11).

Surplus gas in the afterglow chamber can be evacuated via a set of gas outlets (13).

Preferably, the circulation gas is the same as the process gas.

Preferably the process gas comprises any or any combination of the following: nitrogen (N₂), Argon (Ar), Helium (He), carbon dioxide (CO₂), oxygen (O₂), air. Preferably the process gas is an inert gas. In an embodiment, the process gas comprises and preferably is nitrogen (N₂) gas. In an embodiment, the process gas comprises and preferably is carbon dioxide (CO₂) gas. In an embodiment, the process gas comprises and preferably is a noble gas, such as Argon (Ar) and/or Helium (He). Preferably the process gas comprises less than 1 wt% of oxygen (O₂).

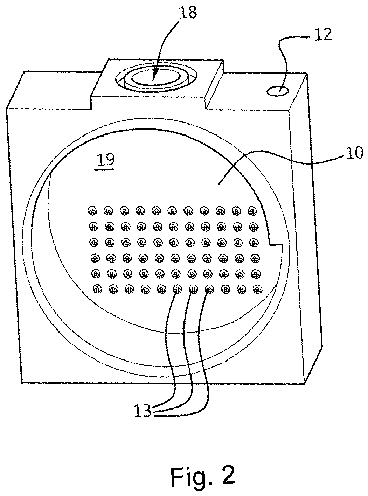

Fig. 2 illustrates an afterglow chamber in accordance with the present invention. Hereby the essentially cylindrical shape of the afterglow chamber (10) is seen in perspective view. The afterglow chamber preferably comprises a back wall (19) which comprises the set of gas outlets (13). The back wall is preferably essentially flat. The afterglow chamber preferably comprises a front wall (not shown on fig. 2 for clarity) opposite the back wall, which preferably is essentially flat. In embodiments, the front wall comprises a set of gas outlets. The precursor-comprising plasma can be injected into the afterglow chamber via the plasma inlet (18) of the afterglow chamber and the azimuthal flow can be induced in the afterglow chamber via the azimuthal flow inlet (12).

Preferably, the process gas is provided at a process gas rate of at least 5 slm, more preferably at least 10 slm. Preferably, the process gas rate is at most 1000 slm, more preferably at most 500 slm. The process gas rate is preferably between 10 slm and 500 slm.

The circulation gas is preferably provided at a circulation gas rate of at least 0.5 slm, more preferably at least 1 slm. Preferably said circulation gas rate is at most 1500 slm, more preferably at most 1000 slm.

In an embodiment, the dielectric (14) comprises any or any combination of the following: polyether ether ketone (PEEK), polystyrene (PS), Ceramics.

In an embodiment, the precursor is provided as a gas or an aerosol. If the precursor is provided as an aerosol, then the aerosol preferably comprises droplets comprising a size of at least 1 nm and/or at most 50 µm.

The precursors which are used in the present invention can be a multitude of precursors.

In an embodiment, the first electrode (2) is connected to and/or supplied with an AC voltage.

The plasma used in the present invention is preferably an atmospheric pressure plasma, more preferably an indirect atmospheric pressure plasma.

The gas outlets may have any size or shape, but preferably have a maximum size which is smaller than the minimum cross sectional size of the 3D objects which are to be treated, such that the 3D objects cannot exit the afterglow chamber through the gas outlets.

In an embodiment, the precursor comprises a UV tracer, such as rhodamine. This allows visual inspection of the coating under UV light.

In an embodiment, the precursor comprises a polymerizable compound. This allows the coating to be a polymer coating. In case the desired coating is a polymer coating, such coating may be obtained by the present method wherein the precursor is the polymerizable compound, whereby the compound can polymerize on the substrate, i.c. the 3D objects, directly. In an embodiment, the coating is a polymer coating.

In an embodiment, the coating is a graft coating.

The precursor may preferably comprise organic materials, including carboxylates, methacrylates, acrylates, styrenes, methacrylonitriles, alkenes and dienes, for example methyl methacrylate, ethyl methacrylate, propyl methacrylate, butyl methacrylate, and other alkyl methacrylates, and the corresponding acrylates, including organofunctional methacrylates and acrylates, including glycidyl methacrylate, trimethoxysilyl propyl methacrylate, allyl methacrylate, hydroxyethyl methacrylate, hydroxypropyl methacrylate, dialkylaminoalkyl methacrylates, and fluoroalkyl (meth)acrylates, methacrylic acid, acrylic acid, fumaric acid and esters, itaconic acid (and esters), maleic anhydride, styrene, α-methylstyrene, halogenated alkenes, for example, vinyl halides, such as vinyl chlorides and vinyl fluorides, and fluorinated alkenes, for example perfluoroalkenes, acrylonitrile, methacrylonitrile, ethylene, propylene, allyl amine, vinylidene halides, butadienes, acrylamide, such as N-isopropylacrylamide, methacrylamide, epoxy compounds, for example glycidoxypropyltrimethoxysilane, glycidol, styrene oxide, butadiene monoxide, ethyleneglycol diglycidylether, glycidyl methacrylate, bisphenol A diglycidylether (and its oligomers), vinylcyclohexene oxide, conducting polymers such as pyrrole and thiophene and their derivatives, and phosphorus-containing compounds, for example dimethylallylphosphonate. Organic precursors may also include an organic compound comprising any one of the following groups alkenyl, aryl, H, -OH, amino groups, aldehyde groups alkyl halide groups, alkyne groups amido groups, carbamate groups, urethane groups, organic salts, carboxylic acid groups and their derivatives such as acid anhydride groups, organic groups containing boron atoms, phosphorus and sulphur containing groups such as mercapto and sulphido groups and grafted or covalently bonded biochemical groups such as amino acids and/or their derivatives, grafted or covalently bonded biochemical species such as proteins, enzymes and DNA.

### Testing examples:

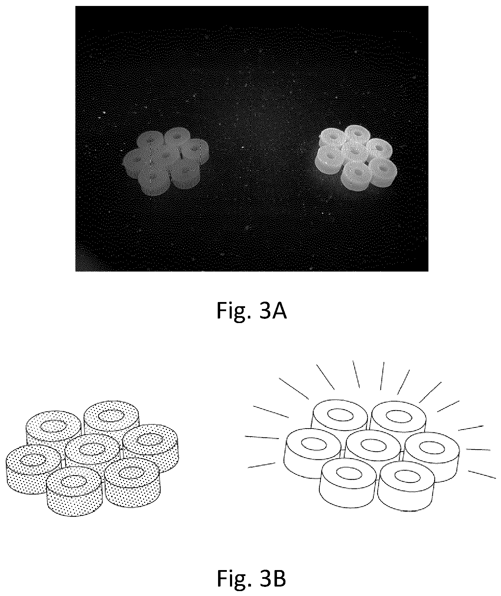

Polypropylene (PP) parts (see figs. 3A and 3B) having a cylindrical shape of about 1 cm diameter and about 5 mm height, with a central hole of about 3 mm in diameter, were coated using the present invention. The precursor comprised an aerosol mixture of hydroxyethylmethacrylate (HEMA) and a small amount rhodamine. The rhodamine acts as a UV tracer, allowing visual inspection of the coating under UV light. It was seen that the coating covered the full surface of each object at all sides and within the central hole. Fig. 3A shows a photograph of uncoated PP parts on the left and coated PP parts on the right for comparison, fig. 3B illustrates the difference under UV light: the coated parts clearly light up homogeneously.

Parameters:
- process gas rate: 80 slm
- circulation gas rate: 35 slm
- aerosol flow rate: 50 slm
- duration: 3 min
- AC electrode voltage: 80 W at 10 kV at 60 kHz
- precursor mixture: about 99 wt% HEMA, 1wt% rhodamine, at about 1.0 g/h consumption rate

The plasma reactor which was used, was a PlasmaSpot from Molecular Plasma Group, having the following possible settings:
- POWER 60 - 450 W
- VOLTAGE 5-25 kV
- FREQUENCY ca. 60 kHz
- PLASMA GAS TYPE: Air, N₂, He, Ar, etc. and mixtures
- PLASMA GAS FLOW: 10 - 250 slm
- RANGE OF PRECURSORS: Liquids, gases, mix of liquids, solutions, dispersions, etc...
- PRECURSOR SUPPLY: Gas flow control, nanometric droplets, ultra-fast change-over
- ATOMIZER COUNTS: 1 to 2
- PRECURSOR CONSUMPTION: 0.3 to 2.5 g/h
- HOMOGENOUS PLASMA AREA: ø 10 - 25 mm
- WORKING DISTANCE: 1 - 20 mm
- WORKING TEMPERATURE: Room temperature
- WORKING PRESSURE: ambient pressure (atmospheric)

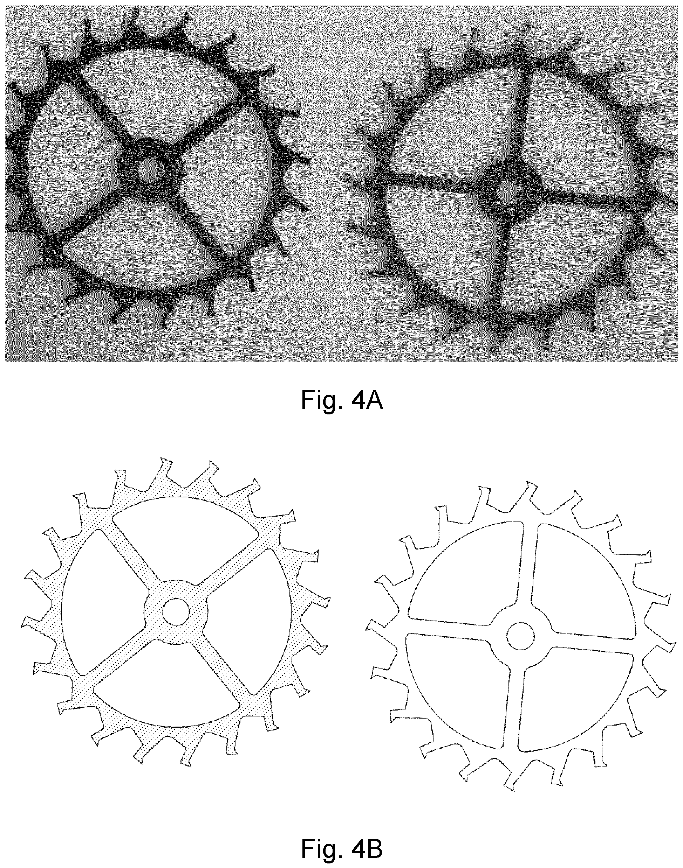

A test using metal gears (see figs. 4A and 4B) having about 1 cm diameter and 3mm height with extending teeth was also performed using essentially the same parameters and settings as for the PP parts, but using a mixture of tetramethyldisiloxane (TMDSO) and rhodamine. Also here, visual inspection under UV light showed a complete coating on all sides and especially on the teeth. Fig. 4A shows a photograph of an uncoated gear on the left and a coated gear on the right for comparison, fig. 4B illustrates the difference under UV light: the coated gear clearly lights up homogeneously.

## Claims

1. An apparatus for plasma coating three-dimensional (3D) objects with a full coating, comprising a plasma reactor and an essentially cylindrically shaped afterglow chamber, wherein the plasma reactor is configured to provide a precursor-comprising plasma flow at a plasma reactor outlet,
wherein the afterglow chamber comprising a plasma inlet, an object inlet, an azimuthal flow inlet and a set of gas outlets, wherein:
- the afterglow chamber is configured to receive and hold a set of 3D objects which are to be coated;
- the object inlet is configured to allow the 3D objects to be inserted into and extracted out of the afterglow chamber, whereby the object inlet is sealable;
- the plasma inlet is in fluid connection with the plasma reactor outlet and is configured to allow a precursor-comprising plasma flow to enter the afterglow chamber,
- the azimuthal flow inlet is configured to ensure an essentially azimuthal flow within the afterglow chamber upon providing a gas flow to said azimuthal flow inlet, and
- the set of gas outlets are configured to allow evacuation of surplus gas from the afterglow chamber such that both the precursor-comprising plasma flow and the azimuthal flow can be maintained.

2. An apparatus according to claim 1, wherein the azimuthal flow inlet is oriented azimuthally to the essentially cylindrically shaped afterglow chamber to ensure an essentially azimuthal flow within the afterglow chamber.

3. An apparatus according to any of the preceding claims, wherein the plasma reactor comprises a plasma discharge chamber and a set of electrodes, which are positioned along the plasma discharge chamber, the set of electrodes being configured to plasmize a process gas in the plasma discharge chamber.

4. An apparatus according to claim 3, wherein a first electrode is positioned on an outer side of the plasma discharge chamber and a second electrode is positioned essentially on an inner side of the plasma discharge chamber, and wherein a dielectric is provided which shields the first electrode from a lumen of the plasma discharge chamber, whereby the plasma discharge chamber is defined by the second electrode and the dielectric.

5. An apparatus according to claim 4, wherein the second electrode comprises a internal channel through which a precursor can be made to flow from a precursor inlet to the plasma reactor outlet.

6. An apparatus according to any of the claims 3 to 5, wherein the electrodes are located outside of the afterglow chamber.

7. A method for plasma coating three-dimensional (3D) objects with a full coating, comprising the steps of:
(a) inserting a set of 3D objects into an essentially cylindrically shaped afterglow chamber;
(b) creating an essentially azimuthal flow in said afterglow chamber, thereby essentially inducing randomized rotational and translational movement of the 3D objects, and
(c) providing a precursor-comprising plasma flow to the afterglow chamber during said movement of the 3D objects, thereby providing a coating on the 3D objects.

8. A method according to claim 7, wherein the precursor-comprising plasma flow is created by plasmizing a process gas at about atmospheric pressure, and subsequently mixing a precursor into the plasmized process gas, thereby creating an indirect atmospheric pressure plasma which is provided to the afterglow chamber as said precursor-comprising plasma flow.

9. A method according to claim 8, wherein the process gas is provided at a process gas rate of at least 5 slm and at most 1000 slm.

10. A method according to any of the claims 7 to 9, whereby the essentially azimuthal flow is created by a circulating gas provided to the afterglow chamber via an azimuthal flow inlet of the afterglow chamber, said azimuthal flow inlet being oriented azimuthally to the essentially cylindrically shaped afterglow chamber.

11. A method according to claim 10, wherein the circulation gas is provided at a circulation gas rate of at least 0.5 slm and at most 1500 slm.

12. A method according to claim 10 or 11, wherein the circulation gas is the same gas as the plasma process gas.

13. A method according to any of the claims 7 to 12, wherein the precursor comprises a UV tracer.

14. A method according to any of the claims 7 to 13, wherein the 3D objects comprise a maximum size which is at least 0.1 mm and/or at most 20.0 mm.
